# EUROPEAN PATENT SPECIFICATION

(11) **EP 2 477 379 B1**
(45) Date of publication and mention of the grant of the patent: **05.12.2018**
(21) Application number: 11160588.7
(22) Date of filing: 31.03.2011
(51) Int. Cl.: H04M 1/60, G01R 31/36

(54) **System and method for displaying electric quantity of bluetooth earphone on portable electronic equipment**
System und Verfahren zur Anzeige der elektrischen Quantität eines Bluetooth-Kopfhörers auf einem tragbaren elektronischen Gerät
Système et procédé d'affichage de la quantité électrique d'écouteur Bluetooth sur un équipement électronique portable

(30) Priority: 17.01.2011 CN 201110020378
(43) Date of publication of application: 18.07.2012
(73) Proprietor: Huizhou TCL Mobile Communication Co., Ltd., Huizhou, Guangdong 516006 (CN)
(72) Inventor: Wu, Yangmin, 516006 Huizhou City Guangdong (CN); Feng, Yike, 516006 Huizhou City Guangdong (CN); Liu, Lian, 516006 Huizhou City Guangdong (CN)
(74) Representative: ZHAOffice SPRL

(56) References cited:
- EP-A1- 2 190 176
- WO-A1-2006/059863
- WO-A1-2007/114850
- WO-A1-2010/083829
- US-A1- 2011 136 437

## Description

### TECHNICAL FIELD

The present disclosure generally relates to short distance wireless communication, and more particularly to systems and methods for displaying an electric quantity of a bluetooth earphone on a portable electronic equipment, and to a bluetooth earphone and a portable electronic equipment.

### BACKGROUND

Bluetooth is a short-distance wireless communication technique and is widely used in any personal mobile communication equipment.

A bluetooth technique has advantages of wide signal-receiving angle, energy saving, high transmission rate and so on. A bluetooth earphone, as the name implies, is an audio device that performs communication using a bluetooth transmission technique. A user can receive voice signals in a wireless transmission range (10 meters) of the bluetooth to, for example, pick up a telephone, listen to music, etc. When a conventional bluetooth earphone interconnects to a mobile terminal, the bluetooth earphone may intermittently cue the user using an LED (Light Emitting Diode) display lamp or using cue tone only if an electric quantity thereof is low. The user cannot view the electric quantity of the bluetooth earphone voluntarily.

Therefore, it is easy to cause a problem of break during a telephone communication, which brings out a significant inconvenience to the user.

The WO patent application WO 2006/059863A1 discloses a battery charge remaining level indicating method of a wireless headset is disclosed. A remaining charge amount of a battery, disposed in a wireless headset and supplying power to the wireless headset, is transmitted to a mobile communication terminal connected to the wireless headset via short-range wireless communication, and indicated on a display. The battery charge remaining level is periodically discriminated by the wireless headset when the wireless headset and the mobile communication terminal are connected via short-range wireless communication. The discriminated information on the battery charge remaining level is transmitted to the mobile communication terminal. The mobile communication terminal discriminates the information on the battery charge remaining level transmitted by the wireless headset and indicates the battery charge remaining level on the display.

The WO patent application WO 2007/114850A1 discloses a system and method of displaying data pertaining to an accessory (100) on a mobile device (200) is disclosed. The accessory (100) and the mobile device (200) are communicable with one another using the BluetoothTM protocol. A set of pre-defined Bluetooth queries using an extended list of AT commands (620) that can be used by the Bluetooth protocol are designed to perform functions that request data pertaining to the accessory (100). A Bluetooth connection is established (730) between the accessory (100) and the mobile device (200). A Bluetooth query is selected by a user (735) of the mobile device (200) and sent to the accessory (100). The accessory (100) receives and executes the Bluetooth query (745) from the mobile device to obtain the requested data pertaining to the accessory (100). The requested data is sent back to the mobile device (200) where it is displayed on the mobile device display (240).

The CN patent application CN 101345554A discloses a method, device and system for displaying the capacity of the blue-tooth device on the mobile terminal with Bluetooth function. The method for displaying the capacity of the blue-tooth device on the mobile terminal with Bluetooth function includes the steps of: the mobile terminal receives the residual capacity value from the Bluetooth device, and the residual capacity is used for indicating the residual capacity of the Bluetooth device; the residual capacity of the Bluetooth device is displayed on the screen of the mobile terminal. By the present invention, the user of the mobile terminal with Bluetooth function can know the capacity status of the Bluetooth device in real time, and the battery will be exchanged or charged in time when the capacity of the Bluetooth device is low, thus avoiding the influence on the using mood or the big loss.

### BRIEF SUMMARY OF THE PRESENT DISCLOSURE

An objective of the present disclosure is to provide a system according to claim 1 for displaying an electric quantity of a bluetooth earphone according to claim 8 on a portable electronic equipment according to claim 10. By the system, a user can examine the electric quantity to judge whether the bluetooth earphone should be charged. Accordingly, a problem that the electric quantity has been exhausted when intending to use the bluetooth earphone or that the power is broken suddenly during usage is addressed. A bluetooth earphone and a portable electronic equipment of above-mentioned system are also disclosed.

The present disclosure also provides a method according to claim 4 for displaying an electric quantity of a bluetooth earphone on a portable electronic equipment.

The present disclosure has following technique effects. The power management module arranged in the bluetooth earphone may obtain the electric quantity parameter of the bluetooth earphone. The control module then controls the first communication module to transmit the electric quantity parameter to the second communication module of the portable electronic equipment, so that the electric quantity can be displayed on the portable electronic equipment. The user can examine the electric quantity to judge whether the bluetooth earphone should be charged. Accordingly, the above-mentioned problem is addressed.

The present disclosure can make the user observe a currently-used electric quantity of the bluetooth earphone when the bluetooth earphone is worn and cannot be observed.

### BRIEF DESCRIPTION OF THE DRA WINGS

The components in the drawings are not necessarily drawn to scale, the emphasis instead being placed upon clearly illustrating the principles of the described embodiments. In the drawings, like reference numerals designate corresponding parts throughout various views, and all the views are schematic.
FIG. 1 is a schematic diagram of a system for displaying an electric quantity of a bluetooth earphone on a portable electronic equipment in accordance with the present disclosure;
FIG. 2 is flow chart of a method for displaying an electric quantity of a bluetooth earphone on a portable electronic equipment in accordance with the present disclosure;
FIG. 3 is a flow chart of a first embodiment of the systems and methods for displaying an electric quantity of a bluetooth earphone on the portable electronic equipment in accordance with the present disclosure;
FIG. 4 is a second embodiment of the systems and methods for displaying an electric quantity of a bluetooth earphone on the portable electronic equipment in accordance with the present disclosure;
FIG. 5 is a third embodiment of the systems and methods for displaying an electric quantity of a bluetooth earphone on the portable electronic equipment in accordance with the present disclosure; and
FIG. 6 is a diagrammatic drawing showing grade icons of electric quantity values of an embodiment of the systems and methods for displaying an electric quantity of a bluetooth earphone on the portable electronic equipment in accordance with the present disclosure.

### DETAILED DESCRIPTION OF EMBODIMENTS

Reference will now be made to the drawings to described exemplary embodiments in detail.

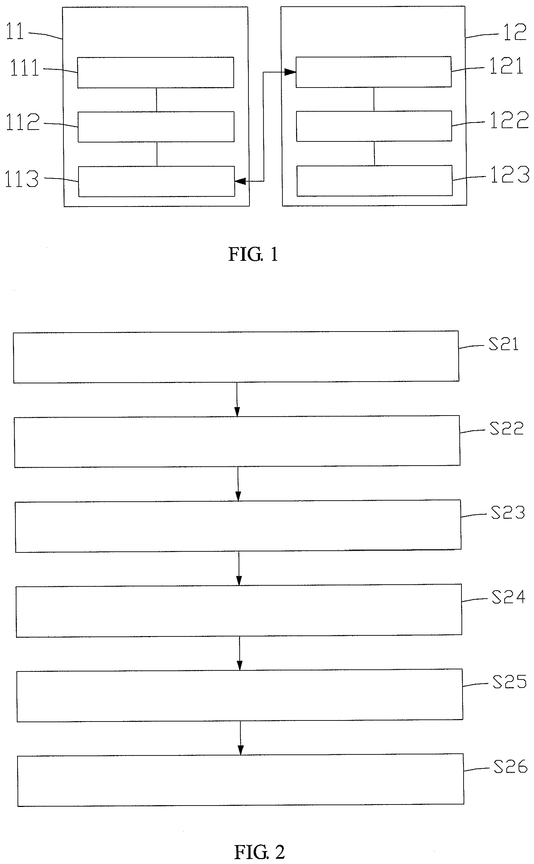

Referring to FIG. 1, a system for displaying an electric quantity of a bluetooth earphone on a portable electronic equipment in accordance with the present disclosure is provided. The system includes a bluetooth earphone 11 and a portable electronic equipment 12. The bluetooth earphone 11 includes a power management module 111, a control module 112 and a first communication module 113. The portable electronic equipment 12 includes a second communication module 121, a processing module 122 and a display module 123.

The power management module 111 computes a current electric quantity value of the bluetooth earphone 11, and converts the electric quantity value into an electric quantity parameter. The control module 112 receives data of the electric quantity parameter from the power management module 111, and transmits the data of the electric quantity parameter to the first communication module 113. The first communication module 113 transmits the data of the electric quantity parameter to the second communication module 121 via a bluetooth transmission protocol. The processing module 122 receives the data of the electric quantity parameter transmitted by the second communication module 121, and converts the electric quantity parameter into an electric quantity value. The display module 123 receives the electric quantity value from the processing module 122, and displays it in the form of an icon.

Specific working steps of the whole system are described as follows. An electric quantity enabling command and an electric quantity transmitting command are registered in the processing module 122 of the portable electronic equipment 12. The electric quantity enabling command is a command of the bluetooth earphone for requesting the portable electronic equipment to enable an electric-quantity display function. When the bluetooth earphone 11 and the portable electronic equipment 12 establish a wireless connection via the first communication module 113 and the second communication module 121, the power management module 111 computes a current electric quantity value of the bluetooth earphone 11 and converts it into an electric quantity parameter. The control module 112 controls the first communication module 113 to transmit the parameter to the second communication module 121 via the electric quantity transmitting command, and transmits the electric quantity enabling command to the second communication module 121 at the same time. The processing module 122 converts the electric quantity parameter received into an electric quantity value according to the electric quantity enabling command that has been registered and temporarily stored, and displays the electric quantity value of the bluetooth earphone 11 via the display module 123.

Referring to FIG. 2, a flow chart of a method for displaying an electric quantity of a bluetooth earphone on a portable electronic equipment is shown. The method for displaying the electric quantity has steps as follows. S21, preliminarily registering an electric quantity enabling command and an electric quantity transmitting command in the processing module. S22, the power management module computes a current electric quantity value of the bluetooth earphone, and transmits the electric quantity value to the control module in the form of electric quantity parameter via the electric quantity transmitting command. S23, the control module controls the first communication module to transmit the electric quantity enabling command and the electric quantity transmitting command to the second communication module. S24, the second communication module receives the electric quantity enabling command and the electric quantity transmitting command and transmits them to the processing module via a bluetooth transmission protocol. S25, the processing module analyzes the two commands according to previous information that is preliminarily registered, and converts the electric quantity parameter received into a corresponding electric quantity value and transmits it to the display module. S26, the display module receives the electric quantity value, and displays a corresponding electric quantity value in form of an icon.

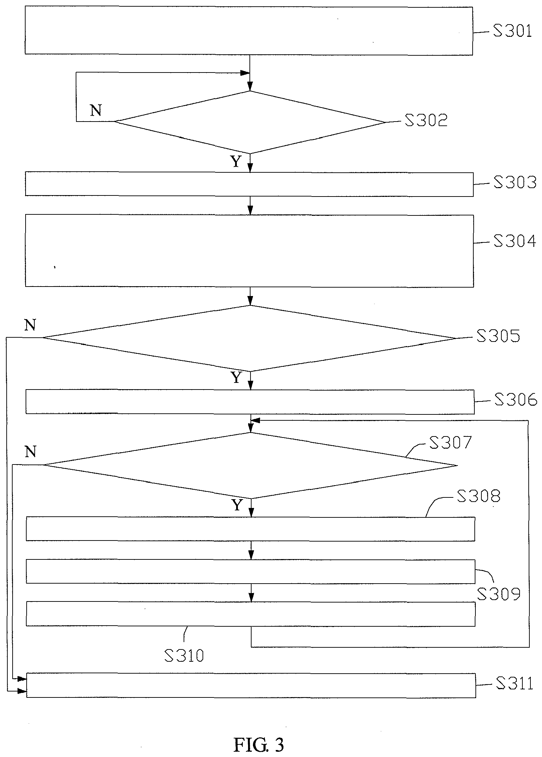

Referring to FIG. 3, a flow chart of a first embodiment in accordance with the present disclosure is shown. The flow chart begins with S301: enabling a bluetooth function of a portable electronic equipment (which may be a mobile communication terminal, a notebook computer, a PDA (Personal Digital Assistant), etc.), and searching for a bluetooth earphone. S302, the electronic equipment searches for the bluetooth earphone, and enquires whether a matching code should be inputted so as to establish a connection. S303, the electronic equipment and the bluetooth earphone are connected by inputting the matching code, and the bluetooth earphone may transmit an electric quantity enabling command to the electronic equipment. S304, the bluetooth earphone enables a function for displaying an electric quantity, and a power management module in the bluetooth earphone computes a current electric quantity value of the bluetooth earphone and converts it into an electric quantity parameter, and transmits the electric quantity parameter at the same time via an electric quantity transmitting command. S305, whether the electronic equipment receives the electric quantity enabling command transmitted by the bluetooth earphone again? If yes, turning to S306. If not, turning to S311. S306, the electronic equipment receives the electric quantity enabling command, and returns a confirmation to the bluetooth earphone. S307, whether the electronic equipment receives an electric quantity transmitting command containing the electric quantity parameter? If yes, turning to S308. If not, turning to S311. S308, the electronic equipment receives the electric quantity transmitting command, and returns a confirmation to the bluetooth earphone. S309, converting the electric quantity parameter into an electric quantity value. S310, the electronic equipment displays the electric quantity value of the bluetooth earphone. Actions from S310 to S306 may continuously cycle to and fro. S311, displaying an icon representing an ordinary connection status between the bluetooth earphone and the electronic equipment.

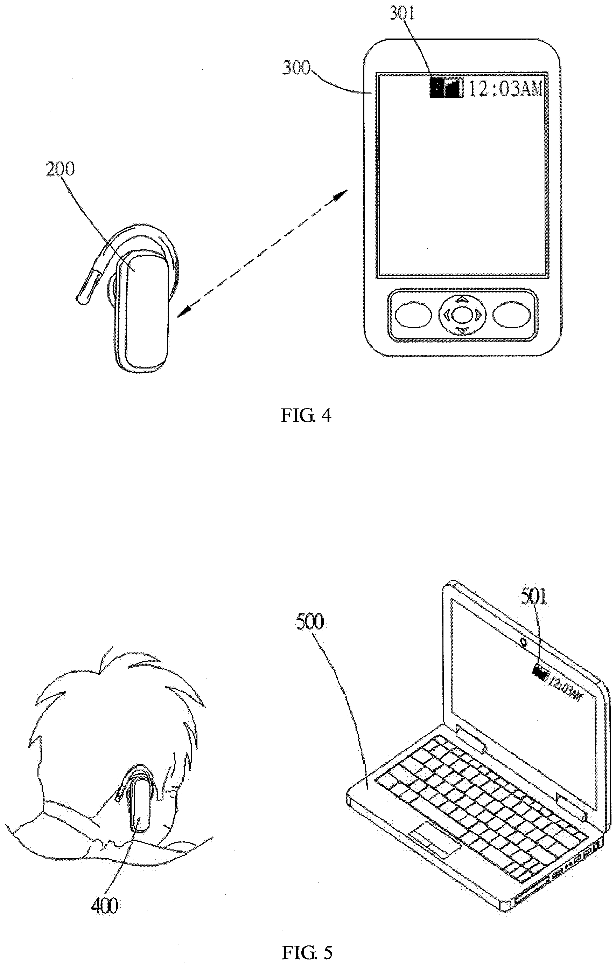

Referring to FIG. 4, a second embodiment in accordance with the present disclosure is shown. In this figure, a user establishes a wireless communication connection between a bluetooth earphone 200 and a mobile communication terminal 300 via a bluetooth technique. When the user establishes the connection via the bluetooth earphone 200, the bluetooth earphone 200 may transmit an electric quantity enabling command and an electric quantity transmitting command to the mobile communication terminal 300. The mobile communication terminal 300 may register the two commands and temporarily store them. Then, a power management module in the bluetooth earphone 200 may compute a current electric quantity value of the bluetooth earphone 200 and convert it into an electric quantity parameter. The bluetooth earphone 200 may transmit the electric quantity parameter to the mobile communication terminal 300 according to an electric quantity enabling command and an electric quantity transmitting command. The mobile communication terminal 300 may perform a comparison according to the electric quantity enabling command and the electric quantity transmitting command which have been registered and temporarily stored, and convert the electric quantity parameter received into an electric quantity value. Then, the electric quantity of the bluetooth earphone is displayed on the mobile communication terminal in form of an icon. In the present disclosure, the mobile communication terminal may be an android mobile communication terminal.

Referring to FIG. 5, a third embodiment of the systems and methods for displaying an electric quantity of a bluetooth earphone on a portable electronic equipment in accordance with the present disclosure is shown. In this figure, a user establishes a wireless communication connection between a bluetooth earphone 400 and a notebook computer 500 via a bluetooth technique. The bluetooth earphone 400 may transmit an electric quantity enabling command and an electric quantity transmitting command to the notebook computer 500, and the notebook computer 500 may register the two commands and temporarily store them. When the user communicates utilizing the bluetooth earphone 400, a power management module in the bluetooth earphone 400 may continuously compute an electric quantity value of the bluetooth earphone 400 and convert it into an electric quantity parameter. Then, the bluetooth earphone 400 may transmit the electric quantity parameter to the notebook computer 500 according to the electric quantity enabling command and the electric quantity transmitting command. The notebook computer 500 may convert the electric quantity parameter into an electric quantity value according to the two commands which have been registered and temporarily stored, and display an electric quantity value icon 501 on its screen. Thus, the electric quantity value of the bluetooth earphone 400 is displayed.

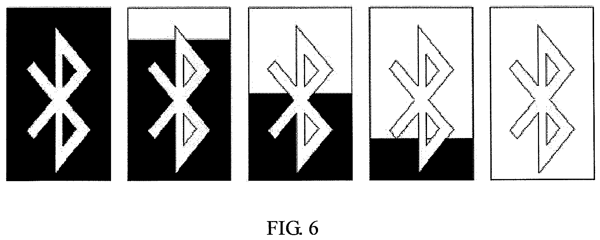

In the third embodiment, a maximum number of the electric quantity value of the bluetooth earphone 400 is 100. The electric quantity value may be divided into five grades. A first grade is 100-80, a second grade is 80-60, a third grade is 60-40, a fourth grade is 40-10, and a fifth grade is 10-0. Icons 501 for corresponding electric quantity values of the five grades are shown in FIG. 6. In this figure, the first grade, the second grade, the third grade, the fourth grade and the fifth grade are illustrated from left to right. When the electric quantity value of the bluetooth earphone 400 changes from a grade to another grade, the bluetooth earphone 400 transmits an electric quantity parameter corresponding to a current electric quantity value grade to the notebook computer 500 according to the electric quantity transmitting command. The notebook computer 500 may display an electric quantity value icon 501 corresponding to the electric quantity value grade of the bluetooth earphone 400 on its screen. Of course, the electric quantity value may be divided into four or six grades as desired.

Referring to FIG. 6, an electric quantity value of a bluetooth earphone is displayed on a portable electronic equipment via five icons in accordance with the present disclosure. Of course, the electric quantity value may be divided into four or six grades as desired. A chip in the bluetooth earphone may define a full earphone electric quantity as 100 while the minimum unit is1, and defines an exhausted electric quantity as 0. The electric quantity value is hereby divided into five grades. The first grade is 100-80, the second grade is 80-60, the third grade is 60-40, the fourth grade is 40-10, and the fifth grade is 10-0. When the electric quantity decreases one unit, the power management module 111 may recompute the electric quantity value of the bluetooth earphone 11 immediately and convert it into an electric quantity parameter. The electric quantity parameter is transmitted to the second communication module 121 via the first communication module 113. The second communication module 121 transmits the electric quantity parameter received to the processing module 122. The processing module 122 converts the parameter into a corresponding electric quantity value, and transmits it to the display module 123. The display module analyzes a current electric quantity value and displays an icon for the current electric quantity. When the electric quantity of the bluetooth earphone 11 changes from a grade to another grade, the display module may analyze according to the current electric quantity value and display a new icon for the electric quantity.

In summary, by utilizing the systems and methods for displaying an electric quantity of a bluetooth earphone on a portable electronic equipment in accordance with the present disclosure, a currently-used electric quantity of the bluetooth earphone can be displayed momentarily. The user can examine the electric quantity to judge whether the bluetooth earphone should be charged. Accordingly, a problem that the electric quantity has been exhausted when intending to use the bluetooth earphone or that the power is broken suddenly during usage is addressed.

It is to be understood, however, that even though numerous characteristics and advantages of preferred and exemplary embodiments have been set out in the foregoing description, together with details of the structures and functions of the embodiments, the disclosure is illustrative only; and that changes may be made in detail within the principles of present disclosure to the full extent indicated by the broad general meaning of the terms in which the appended claims are expressed.

## Claims

1. A system for displaying an electric quantity of a bluetooth earphone on a portable electronic equipment, comprising:
a bluetooth earphone (11) comprising:
a first communication module (113);
a power management module (111) for computing a current electric quantity value of the bluetooth earphone and converting the electric quantity value into an electric quantity parameter; and
a control module (112) for receiving the electric quantity parameter from the power management module (111) and transmitting the electric quantity parameter to the first communication module (113); and
a portable electronic equipment (12) comprising:
a second communication module (121),
a processing module (122); and
a display module (123);
**characterised in that**, the second communication module (121) is adapted to receive the electric quantity parameter transmitted by the first communication module (113) via a bluetooth transmission protocol, the processing module (122) is adapted to receive the electric quantity parameter transmitted by the second communication module (121) and to convert the electric quantity parameter into an electric quantity value, and the display module (123) is adapted to receive the electric quantity value from the processing module (122) and to display it in form of an icon, wherein, the control module (112) is adapted to control the first communication module (113) to transmit an electric quantity enabling command, the electric quantity enabling command being a command of the bluetooth earphone (11) for requesting the portable electronic equipment (12) to enable an electric-quantity display function, and an electric quantity transmitting command containing the electric quantity parameter to the second communication module (121) at the same time, wherein, the bluetooth earphone (11) is adapted to transmit an electric quantity enabling command to the electronic equipment (12) a first time when the electronic equipment (12) and the bluetooth earphone (11) are connected, and wherein the bluetooth earphone (11) is adapted to transmit the electric quantity transmitting command when it transmits the electric quantity enabling command again.

2. The system for displaying an electric quantity of a bluetooth earphone on a portable electronic equipment according to claim 1, wherein the portable electronic equipment (12) is a mobile communication terminal, a notebook computer, or a personal digital assistant.

3. The system for displaying an electric quantity of a bluetooth earphone on a portable electronic equipment according to claim 1, wherein the electric quantity value is divided into a plurality of grades, and wherein when the electric quantity value of the bluetooth earphone (11) changes from a grade to another grade, the display module (123) is adapted to perform analysis and to display a new icon for the electric quantity value.

4. A method for displaying an electric quantity of a bluetooth earphone on a portable electronic equipment, the bluetooth earphone (11) comprising a first communication module (113), a power management module (111) and a control module (112), the portable electronic equipment (12) comprising a second communication module (121), a processing module (122) and a display module (123), **characterised in that**, the method for displaying the electric quantity comprises the following steps:
the power management module (111) computing a current electric quantity value of the bluetooth earphone (11) and converting the electric quantity value into an electric quantity parameter;
the control module (112) controlling the first communication module (113) to transmit the electric quantity parameter;
the second communication module (121) receiving the electric quantity parameter via a bluetooth transmission protocol;
the processing module (122) converting the electric quantity parameter into an electric quantity value; and
the display module (123) displaying the electric quantity value in form of an icon, wherein the control module (112) controls the first communication module (113) to transmit an electric quantity enabling command, the electric quantity enabling command being a command of the bluetooth earphone (11) for requesting the portable electronic equipment (12) to enable an electric-quantity display function, and an electric quantity transmitting command containing the electric quantity parameter to the second communication module (121) at the same time, wherein the bluetooth earphone (11) transmits an electric quantity enabling command to the electronic equipment (12) a first time when the electronic equipment (12) and the bluetooth earphone (11) are connected, and wherein the bluetooth earphone (11) transmits the electric quantity transmitting command when it transmits the electric quantity enabling command again.

5. The method for displaying an electric quantity of a bluetooth earphone on a portable electronic equipment according to claim 4, wherein the display module (123) displays the electric quantity value in form of an image.

6. The method for displaying an electric quantity of a bluetooth earphone on a portable electronic equipment according to claim 4, wherein the electric quantity value is divided into a plurality of grades, and wherein when the electric quantity value of the bluetooth earphone changes from a grade to another grade, the display module (123) performs analysis and displays a new icon for the electric quantity.

7. The method for displaying an electric quantity of a bluetooth earphone on a portable electronic equipment according to claim 4, wherein the portable electronic equipment (12) is a mobile communication terminal, a notebook computer, or a personal digital assistant.

8. A bluetooth earphone (11), comprising:
a first communication module (113);
a power management module (111) for computing a current electric quantity value of the bluetooth earphone (11) and converting the electric quantity value into an electric quantity parameter; and
a control module (112) for receiving the electric quantity parameter from the power management module (111) and transmitting the electric quantity parameter to the first communication module (113);
**characterised in that**, the first communication module (113) is configured for transmitting the electric quantity parameter to a second communication module (121) arranged in a portable electronic equipment (12), the control module (112) is adapted to control the first communication module (113) to transmit an electric quantity enabling command, the electric quantity enabling command being a command of the bluetooth earphone (11) for requesting the portable electronic equipment (12) to enable an electric-quantity display function, and an electric quantity transmitting command containing the electric quantity parameter to the second communication module (121) at the same time, wherein, the bluetooth earphone (11) is adapted to transmit an electric quantity enabling command to the electronic equipment (12) a first time when the electronic equipment (12) and the bluetooth earphone (11) are connected, and wherein the bluetooth earphone (11) is adapted to transmit the electric quantity transmitting command when it transmits the electric quantity enabling command again.

9. The bluetooth earphone according to claim 8, wherein the portable electronic equipment (12) is a mobile communication terminal, a notebook computer, or a personal digital assistant.

10. A portable electronic equipment (12), comprising:
a second communication module (121),
a processing module (122); and
a display module (123);
**characterised in that**, the second communication module (121) is configured for receiving an electric quantity parameter transmitted by a first communication module (113) arranged in a bluetooth earphone (11) via a bluetooth transmission protocol, the processing module is adapted to receive the electric quantity parameter transmitted by the second communication module (121) and to convert the electric quantity parameter into an electric quantity value, and the display module (123) is adapted to receive the electric quantity value from the processing module (122) and to display it in form of an icon; and
wherein the second communication module (121) is adapted to receive an electric quantity enabling command, the electric quantity enabling command being a command of the bluetooth earphone (11) for requesting the portable electronic equipment (12) to enable an electric-quantity display function, and an electric quantity transmitting command containing the electric quantity parameter at the same time, wherein, the portable electronic equipment (12) is adapted to receive an electric quantity enabling command a first time when the electronic equipment (12) and the bluetooth earphone (11) are connected, and wherein the electronic equipment (12) is adapted to receive the electric quantity transmitting command when it receives the electric quantity enabling command transmitted by the bluetooth earphone (11) again.

11. The portable electronic equipment according to claim 10, wherein the portable electronic equipment (12) is a mobile communication terminal, a notebook computer, or a personal digital assistant.

## Patentansprüche

1. System zur Anzeige der elektrischen Quantität eines Bluetooth-Kopfhörers auf einem tragbaren elektronischen Gerät, umfassend:
einen Bluetooth-Kopfhörer (11), der ein erstes Kommunikationsmodul (113), ein Energieverwaltungsmodul (111) zur Berechnung eines aktuellen elektrischen Quantitätswertes des Bluetooth-Kopfhörers und zur Umwandlung des elektrischen Quantitätswertes in einen elektrischen Quantitätsparameter, und ein Steuermodul (112) zum Empfang des elektrischen Quantitätsparameters vom Energieverwaltungsmodul (111) und zur Übertragung des elektrischen Quantitätsparameters an das erste Kommunikationsmodul (113) umfasst; und
ein tragbares elektronisches Gerät (12), das ein zweites Kommunikationsmodul (121), ein Verarbeitungsmodul (122); und ein Anzeigemodul (123) umfasst;
**dadurch gekennzeichnet, dass** das zweite Kommunikationsmodul (121) an den Empfang des elektrischen Quantitätsparameters, der vom ersten Kommunikationsmodul (113) über ein Bluetooth-Übertragungsprotokoll übertragen ist, angepasst ist, das Verarbeitungsmodul (122) an den Empfang des elektrischen Quantitätsparameters, der vom zweiten Kommunikationsmodul (113) übertragen ist, und an die Umwandlung des elektrischen Quantitätsparameters in einen elektrischen Quantitätswert angepasst ist, und das Anzeigemodul (123) am Empfang des elektrischen Quantitätswertes vom dem Verarbeitungsmodul (122) und an dessen Anzeige in Form eines Ikons angepasst ist, wobei das Steuermodul (112) an die Steuerung des ersten Kommunikationsmoduls (113) zur Übertragung eines eine elektrische Quantität aktivierenden Befehls angepasst ist , wobei der eine elektrische Quantität aktivierende Befehl ein Befehl des Bluetooth-Kopfhörers (11) ist zur Anforderung des tragbaren elektronischen Gerät (12) eine Anzeigefunktion einer elektrischen Quantität zu aktivieren, und gleichzeitig zur Übertragung eines eine elektrische Quantität übertragenden Befehls, der den elektrischen Parameter umfasst, an das zweite Kommunikationsmodul (121) angepasst ist, wobei der Bluetooth-Kopfhörer (11) an die erstmalige Übertragung eines eine elektrische Quantität aktivierenden Befehls an das elektronische Gerät (12) angepasst ist, wenn das elektronische Gerät (12) und der Bluetooth-Kopfhörer (11) verbunden sind, und wobei der Bluetooth-Kopfhörer (11) an die Übertragung eines eine elektrische Quantität übertragenden Befehls an das elektronische Gerät (12) angepasst ist, wenn er den eine elektrische Quantität aktivierenden Befehl wieder überträgt.

2. System zur Anzeige der elektrischen Quantität eines Bluetooth-Kopfhörers auf einem tragbaren elektronischen Gerät nach Anspruch 1, wobei das tragbare elektronische Gerät (12) ein mobiles Kommunikationsendgerät, ein Notebook, oder ein PDA ist.

3. System zur Anzeige der elektrischen Quantität eines Bluetooth-Kopfhörers auf einem tragbaren elektronischen Gerät nach Anspruch 1, wobei der elektrische Quantitätswert in eine Mehrzahl von Graden unterteilt ist, und wobei, wenn der elektrische Quantitätswert sich von einem Grad in eine andere ändert, das Anzeigemodul (123) an die Ausführung einer Analyse und an die Anzeige eines neuen Ikons für den elektrischen Quantitätswert angepasst ist.

4. Verfahren zur Anzeige der elektrischen Quantität eines Bluetooth-Kopfhörers auf einem tragbaren elektronischen Gerät, wobei der Bluetooth-Kopfhörer (11) ein erstes Kommunikationsmodul (113), ein Energieverwaltungsmodul (111) und ein Steuermodul (112) umfasst, wobei das tragbare elektronische Gerät (12) ein zweites Kommunikationsmodul (121), ein Verarbeitungsmodul (122) und ein Anzeigemodul (123) umfasst;
**dadurch gekennzeichnet, dass** das Verfahren zur Anzeige der elektrischen Quantität die folgenden Schritte umfasst:
das Energieverwaltungsmodul (111) berechnet einen aktuellen elektrischen Quantitätswert des Bluetooth-Kopfhörers (11) und wandelt den elektrischen Quantitätswert in einen elektrischen Quantitätsparameter um;
das Steuermodul (112) steuert das erste Kommunikationsmodul (113) zur Übertragung des elektrischen Quantitätsparameters;
das zweite Kommunikationsmodul (121) empfängt den elektrischen Quantitätsparameter über ein Bluetooth-Übertragungsprotokoll;
das Verarbeitungsmodul (122) wandelt den elektrischen Quantitätsparameter in einen elektrischen Quantitätswert um; und
das Anzeigemodul (123) zeigt den elektrischen Quantitätswert in Form eines Ikons an, wobei das Steuermodul (112) das erste Kommunikationsmodul (113) zur Übertragung eines eine elektrische Quantität aktivierenden Befehls steuert, wobei der eine elektrische Quantität aktivierende Befehl ein Befehl ist zur Anforderung des tragbaren elektronischen Geräts (12) eine Anzeigefunktion einer elektrischen Quantität zu aktivieren, und gleichzeitig zur Übertragung eines eine elektrische Quantität übertragenden Befehls, der den elektrischen Parameter umfasst, an das zweite Kommunikationsmodul (121) steuert, wobei der Bluetooth-Kopfhörer (11) erstmalig ein eine elektrische Quantität aktivierenden Befehl an das elektronische Gerät (12) überträgt, wenn das elektronische Gerät (12) und der Bluetooth-Kopfhörer (11) verbunden sind, und wobei der Bluetooth-Kopfhörer (11) einen eine elektrische Quantität übertragenden Befehl an das elektronische Gerät (12) überträgt, wenn er den eine elektrische Quantität aktivierenden Befehl wieder überträgt.

5. Verfahren zur Anzeige der elektrischen Quantität eines Bluetooth-Kopfhörers auf einem tragbaren elektronischen Gerät nach Anspruch 4, wobei das Anzeigemodul (123) den elektrischen Quantitätswert in Form eines Bildes anzeigt.

6. Verfahren zur Anzeige der elektrischen Quantität eines Bluetooth-Kopfhörers auf einem tragbaren elektronischen Gerät nach Anspruch 4, wobei der elektrische Quantitätswert in eine Mehrzahl von Graden unterteilt ist, und wobei, wenn der elektrische Quantitätswert sich von einem Grad in eine andere ändert, das Anzeigemodul (123) eine Analyse ausführt und ein neues Ikon für den elektrischen Quantitätswert anzeigt.

7. Verfahren zur Anzeige der elektrischen Quantität eines Bluetooth-Kopfhörers auf einem tragbaren elektronischen Gerät nach Anspruch 4, wobei das tragbare elektronische Gerät (12) ein mobiles Kommunikationsendgerät, ein Notebook, oder ein PDA ist.

8. Bluetooth-Kopfhörer (11), umfassend:
ein erstes Kommunikationsmodul (113) ;
ein Energieverwaltungsmodul (111) zur Berechnung eines aktuellen elektrischen Quantitätswertes des Bluetooth-Kopfhörers (11) und zur Umwandlung des elektrischen Quantitätswertes in einen elektrischen Quantitätsparameter; und
ein Steuermodul (112) zum Empfang des elektrischen Quantitätsparameters vom Energieverwaltungsmodul (111) und zur Übertragung des elektrischen Quantitätsparameters an das erste Kommunikationsmodul (113);
**dadurch gekennzeichnet, dass** das erste Kommunikationsmodul (113) zur Übertragung des elektrischen Quantitätsparameters an ein zweites Kommunikationsmodul (121) konfiguriert ist, das in einem tragbaren elektronischen Gerät angeordnet ist, das Steuermodul (112) das an die Steuerung des ersten Kommunikationsmoduls (113) zur Übertragung eines eine elektrische Quantität aktivierenden Befehls angepasst ist, wobei der eine elektrische Quantität aktivierende Befehl ein Befehl des Bluetooth-Kopfhörers (11) ist zur Anforderung des tragbaren elektronischen Gerät (12) eine Anzeigefunktion einer elektrischen Quantität zu aktivieren, und gleichzeitig zur Übertragung eines eine elektrische Quantität übertragenden Befehls, der den elektrischen Parameter umfasst, an das zweite Kommunikationsmodul (121) angepasst ist, wobei der Bluetooth-Kopfhörer (11) an die erstmalige Übertragung eines eine elektrische Quantität aktivierenden Befehls an das elektronische Gerät (12) angepasst ist, wenn das elektronische Gerät (12) und der Bluetooth-Kopfhörer (11) verbunden sind, und wobei der Bluetooth-Kopfhörer (11) an die Übertragung eines eine elektrische Quantität übertragenden Befehls an das elektronische Gerät (12) angepasst ist, wenn er den eine elektrische Quantität übertragenden Befehl wieder überträgt.

9. Bluetooth-Kopfhörer nach Anspruch 8, wobei das tragbare elektronische Gerät (12) ein mobiles Kommunikationsendgerät, ein Notebook, oder ein PDA ist.

10. Tragbares elektronisches Gerät (12), umfassend:
ein zweites Kommunikationsmodul (121),
ein Verarbeitungsmodul (122); und
ein Anzeigemodul (123);
**dadurch gekennzeichnet, dass** das zweite Kommunikationsmodul (121) zum Empfang des elektrischen Quantitätsparameters konfiguriert ist, der von einem in einem Bluetooth-Kopfhörer angeordneten ersten Kommunikationsmodul (113) über ein Bluetooth-Übertragungsprotokoll übertragen ist, das Verarbeitungsmodul (122) an den Empfang des elektrischen Quantitätsparameters, der vom zweiten Kommunikationsmodul (121) übertragen ist, und an die Umwandlung des elektrischen Quantitätsparameters in einen elektrischen Quantitätswert angepasst ist, und das Anzeigemodul (123) an den Empfang des elektrischen Quantitätswertes vom dem Verarbeitungsmodul (122) und an dessen Anzeige in Form eines Ikons angepasst ist, und wobei das zweite Kommunikationsmodul (121) an den Empfang eines eine elektrische Quantität aktivierenden Befehls angepasst ist, wobei der eine elektrische Quantität aktivierende Befehl ein Befehl ist zur Anforderung des tragbaren elektronischen Gerät (12) eine Anzeigefunktion einer elektrischen Quantität zu aktivieren, und gleichzeitig an die Übertragung eines eine elektrische Quantität übertragenden Befehls, der den elektrischen Parameter umfasst, an das zweite Kommunikationsmodul (121) angepasst ist, wobei das tragbare elektronische Gerät (12) an den erstmaligen Empfang eines eine elektrische Quantität aktivierenden Befehls angepasst ist, wenn das elektronische Gerät (12) und der Bluetooth-Kopfhörer (11) verbunden sind, und wobei das tragbare elektronische Gerät (12) an den Empfang eines eine elektrische Quantität übertragenden Befehls angepasst ist, wenn es den eine elektrische Quantität aktivierenden Befehl, der vom Bluetooth-Kopfhörer (11) übertragen ist, wieder empfängt.

11. Tragbares elektronisches Gerät nach Anspruch 10, wobei das tragbare elektronische Gerät (12) ein mobiles Kommunikationsendgerät, ein Notebook, oder ein PDA ist.

## Revendications

1. Système d'affichage d'une quantité électrique d'un écouteur bluetooth sur un équipement électronique portable, comprenant:
un écouteur bluetooth (11) comprenant : un premier module de communication (113); un module de gestion d'énergie électrique (111) apte à calculer une valeur actuelle de quantité électrique de l'écouteur bluetooth et à convertir la valeur de la quantité électrique en un paramètre de quantité électrique; et un module de commande (112) apte à recevoir le paramètre de quantité électrique du module de gestion d'énergie électrique (111) et à transmettre le paramètre de quantité électrique au premier module de communication (113); et
un équipement électronique portable (12) comprenant: un deuxième module de communication (121), un module de traitement (122); et un module d'affichage (123);
système **caractérisé en ce que** le deuxième module de communication (121) est adapté pour recevoir le paramètre de quantité électrique transmis par le premier module de communication (113) par l'intermédiaire d'un protocole de transmission bluetooth, le module de traitement (122) est adapté pour recevoir le paramètre de quantité électrique transmis par le deuxième module de communication (121) et pour convertir le paramètre de quantité électrique en une valeur de quantité électrique, et le module d'affichage (123) est adapté pour recevoir la valeur de quantité électrique du module de traitement (122) et à l'afficher sous forme d'une icône, système dans lequel le module de commande (112) est adapté pour commander le premier module de communication (113) afin qu'il transmette une instruction activant une quantité électrique, l'instruction activant une quantité électrique étant une instruction de l'écouteur bluetooth (11) destinée à demander à l'équipement électronique portable (12) de permettre une fonction d'affichage d'une quantité électrique, et en même temps une instruction de transmission d'une quantité électrique contenant le paramètre de quantité électrique vers le deuxième module de communication (121), système dans lequel l'écouteur bluetooth est adapté pour transmettre une instruction activant une quantité électrique à l'équipement électronique (12) une première fois lorsque l'équipement électronique (12) et l'écouteur bluetooth sont connectés, et dans lequel l'écouteur bluetooth (11) est adapté pour transmettre une instruction de transmission d'une quantité électrique lorsqu'il transmet une nouvelle fois l'instruction activant une quantité électrique.

2. Système d'affichage d'une quantité électrique d'un écouteur bluetooth sur un équipement électronique portable selon la revendication 1, dans lequel l'équipement électronique portable (12) est un terminal de communication mobile, un ordinateur portatif ou un assistant numérique personnel.

3. Système d'affichage d'une quantité électrique d'un écouteur bluetooth sur un équipement électronique portable selon la revendication 1, dans lequel la valeur de quantité électrique est divisée en une pluralité de degrés, et dans lequel la valeur de quantité électrique de l'écouteur bluetooth (11) change d'un degré en un autre, le module d'affichage (123) est adapté pour réaliser une analyse et pour afficher une nouvelle icône pour la valeur de quantité électrique.

4. Procédé d'affichage d'une quantité électrique d'un écouteur bluetooth sur un équipement électronique portable, l'écouteur bluetooth (11) comprenant un premier module de communication (113), un module de gestion d'énergie électrique (111) et un module de commande (112), l'équipement électronique portable (12) comprenant un deuxième module de communication (121), un module de traitement (122); et un module d'affichage (123), **caractérisé en ce que** le procédé d'affichage de la quantité électrique comprend les étapes suivantes:
le module de gestion d'énergie électrique (111) calcule une valeur actuelle de quantité électrique de l'écouteur bluetooth (11) et convertit la valeur actuelle de quantité électrique en un paramètre de quantité électrique;
le module de commande (112) commande le premier module de communication (113) afin qu'il transmette le paramètre de quantité électrique;
le deuxième module de communication (121) reçoit le paramètre de quantité électrique par l'intermédiaire d'un protocole de transmission bluetooth;
le module de traitement (122) convertit le paramètre de quantité électrique en une valeur de quantité électrique; et
le module d'affichage (123) affiche la quantité électrique sous la forme d'une icône, procédé dans lequel le module de commande (112) commande le premier module de communication (113) afin qu'il transmette une instruction activant une quantité électrique, l'instruction activant une quantité électrique étant une instruction de l'écouteur bluetooth (11) destinée à demander à l'équipement électronique portable (12) de permettre une fonction d'affichage d'une quantité électrique, et en même temps une instruction de transmission d'une quantité électrique contenant le paramètre de quantité électrique vers le deuxième module de communication (121), procédé dans lequel l'écouteur bluetooth (11) transmet une instruction activant une quantité électrique à l'équipement électronique (12) une première fois lorsque l'équipement électronique (12) et l'écouteur bluetooth (11) sont connectés, et dans lequel l'écouteur bluetooth (11) transmet l'instruction de transmission d'une quantité électrique lorsqu'il transmet une nouvelle fois l'instruction activant une quantité électrique.

5. Procédé d'affichage d'une quantité électrique d'un écouteur bluetooth sur un équipement électronique portable selon la revendication 4, dans lequel le module d'affichage (123) affiche la valeur de quantité électrique sous forme d'une image.

6. Procédé d'affichage d'une quantité électrique d'un écouteur bluetooth sur un équipement électronique portable selon la revendication 4, dans lequel la valeur de quantité électrique est divisée en une pluralité de degrés, et dans lequel, lorsque la valeur de quantité électrique change d'un degré en un autre, le module d'affichage (123) réalise une analyse et affiche une nouvelle icône pour la quantité électrique.

7. Procédé d'affichage d'une quantité électrique d'un écouteur bluetooth sur un équipement électronique portable selon la revendication 4, dans lequel l'équipement électronique portable (12) est un terminal de communication mobile, un ordinateur portatif ou un assistant numérique personnel.

8. Ecouteur bluetooth (11), comprenant:
un premier module de communication (113);
un module de gestion d'énergie électrique (111) apte à calculer une valeur actuelle de quantité électrique de l'écouteur bluetooth (11) et à convertir la valeur de quantité électrique en un paramètre de quantité électrique; et
un module de commande (112) apte à recevoir le paramètre de quantité électrique du module de gestion d'énergie électrique et à transmettre le paramètre de quantité électrique au premier module de communication (113);
**caractérisé en ce que** le premier module de communication (113) est configuré pour transmettre le paramètre de quantité électrique à un deuxième module de communication (121) disposé dans un équipement électronique portable (12), le module de commande (112) est adapté pour commander le premier module de communication (113) afin qu'il transmette une instruction activant une quantité électrique, l'instruction activant une quantité électrique étant une instruction de l'écouteur bluetooth (11) destinée à demander à l'équipement électronique portable (12) de permettre une fonction d'affichage d'une quantité électrique, et en même temps une instruction de transmission d'une quantité électrique contenant le paramètre de quantité électrique vers le deuxième module de communication (121), écouteur dans lequel l'écouteur bluetooth (11) est adapté pour transmettre une instruction activant une quantité électrique à l'équipement électronique (12) une première fois lorsque l'équipement électronique (12) et l'écouteur bluetooth sont connectés, et dans lequel l'écouteur bluetooth (11) est adapté pour transmettre l'instruction de transmission d'une quantité électrique lorsqu'il transmet une nouvelle fois l'instruction activant une quantité électrique.

9. Ecouteur bluetooth selon la revendication 8, dans lequel l'équipement électronique portable (12) est un terminal de communication mobile, un ordinateur portatif ou un assistant numérique personnel.

10. Equipement électronique portable (12), comprenant
un deuxième module de communication (121),
un module de traitement (122); et
un module d'affichage (123);
**caractérisé en ce que** le deuxième module de communication (121) est configuré pour recevoir un paramètre de quantité électrique transmis par un premier module de communication (113) disposé dans un écouteur bluetooth (11) par l'intermédiaire d'un protocole de transmission bluetooth, le module de traitement est adapté pour recevoir le paramètre de quantité électrique transmis par le module deuxième module de communication (121) et pour convertir le paramètre de quantité électrique en une valeur de quantité électrique, et le module d'affichage (123) est adapté pour recevoir la valeur de quantité électrique du module de traitement (122) et pour l'afficher sous forme d'une icône, et équipement électronique dans lequel le deuxième module de communication (121) est adapté pour recevoir une instruction activant une quantité électrique, l'instruction activant une quantité électrique étant une instruction de l'écouteur bluetooth (11) destinée à demander à l'équipement électronique portable (12) de permettre une fonction d'affichage d'une quantité électrique, et en même temps une instruction de transmission d'une quantité électrique contenant le paramètre de quantité électrique, équipement électronique portable dans lequel l'équipement électronique portable (12) est adapté pour transmettre une instruction activant une quantité électrique à l'équipement électronique (12) une première fois lorsque l'équipement électronique (12) et l'écouteur bluetooth (11) sont connectés, et dans lequel l'équipement électronique (12) est adapté pour recevoir l'instruction de transmission d'une quantité électrique lorsqu'il reçoit une nouvelle fois l'instruction activant une quantité électrique transmise par l'écouteur bluetooth (11).

11. Equipement électronique portable selon la revendication 10, dans lequel l'équipement électronique portable (12) est un terminal de communication mobile, un ordinateur portatif ou un assistant numérique personnel.
